# EUROPEAN PATENT APPLICATION

(11) **EP 4 845 035 A1**
(43) Date of publication of application: **25.11.2026**
(21) Application number: 25777501.5
(22) Date of filing: 25.03.2025
(51) Int. Cl.: H03M 1/66, H03M 1/68

(54) **D/A CONVERTER**

(30) Priority: 28.03.2024 JP 2024052936
(71) Applicant: NTT Innovative Devices Corporation, Yokohama-shi, Kanagawa 221-0031 (JP)
(72) Inventor: TSUKAMOTO, Sanroku, Yokohama-shi, Kanagawa 221-0031 (JP); ENDO, Masahiro, Yokohama-shi, Kanagawa 221-0031 (JP)
(74) Representative: Parker, Andrew James
(86) International application number: PCT/JP2025/011863
(87) International publication number: WO 2025/205847

(57) **Abstract**

A resistor (R+) converts a total current of the plurality of current-source units (3) into an analog output voltage. Each current-source unit (3) inputs first to fourth overlapping clocks (Φ₁ to Φ₄) having phases sequentially shifted by 90° and first to fourth digital inputs (Dᵢ₁ to Dᵢ₄) which are portions of the digital input corresponding to each current-source unit (3) and synchronized with the first to fourth overlapping clocks (Φ₁ to Φ₄) respectively. Each current-source unit (3) has first to fourth switch sections (SW₁ to SW₄) connected in parallel with each other, and a current source (I₀) connected in series with the first to fourth switch sections (SW₁ to SW₄). The first switch section (SW₁) outputs a current from the current source (I₀) in response to the first digital input (Dᵢ₁) during a period in which the first and second overlapping clocks (Φ₁, Φ₂) overlap. The same applies to the switch section (SW₂ to SW₄).

## Description

### Technical Field

The present invention relates to a D/A converter.

### Background

A current-output D/A converter (hereafter abbreviated as "DAC") has been practically used as the highest-speed conversion-type DAC, delivers a current from a current-source cell to a resistor to convert the current into an analog voltage, and outputs the analog voltage. Current-source cells are roughly classified into two: a unary configuration having a plurality of current-source units with the same current value; and a binary configuration having a plurality of current-source units weighted with a current value ratio of powers of two.

In the unary configuration, the number of current-source units that output a current is controlled in response to a digital input. In the binary configuration, the current-source unit that outputs a current is selected in response to a digital input. Consequently, the current value of the current-source cell is controlled in response to the digital input, and an analog voltage with a magnitude corresponding to the digital input is output.

Each bit of the digital input has a binary weight (a power of two). The D/A converter outputs the analog voltage with a magnitude corresponding to the weight. In the case of 8 bits, the weight ratios from the least significant bit to the most significant bit are 1, 2, 4, ... 64, 128. In the binary configuration in which the weight ratios are directly set as the current amounts of a plurality of current-source units, the current amounts of current-source cells from the least significant to the most significant are I₀ = 1I, I₁ = 2I, I₂ = 4I, ... I₇ = 128I in order from the least significant bit.

However, a problem occurs during a carry transition, for example, when transitioning from 127 (01111111) to 128 (10000000). At 127, a current of I₀ + I₁ + I₂ + I₃ + I₄ + I₅ + I₆ flows, and at 128, a current of I₇ flows. The current-source units that deliver the currents are completely switched between 127 and 128, and, therefore, if there is an error in the current amount of each of the current-source units and the errors are superimposed in a biased manner toward the positive or negative side, a large error (differential nonlinearity error) occurs.

On the other hand, in the unary configuration, a current of 127I flows at 127, and a current of 127I + 1I flows at 128. Therefore, no error is superimposed, and there is only an error associated with the added 1I, thereby reducing the error. For this reason, the unary configuration is more advantageous in terms of accuracy. However, a logic circuit is required to perform decoding processing (also called binary-unary conversion or binary-thermometer conversion) for converting a binary code, which is input to a current-source cell of the unary configuration, into a thermometer code.

For this binary-unary conversion, the greater the number of binary digits, the more stages of logical processing are required and the longer the processing time of the logic circuit. This delay also causes a delay in switching of switches in the current-source cells, resulting in a slower conversion speed. Therefore, considering a trade-off between accuracy and speed, a segment configuration in which the higher side is configured as a unary configuration and the lower side is configured as a binary configuration is often used.

The current-source unit includes a current source that delivers a current with a constant current value, and a switch that controls whether or not to output the current (see, for example, NPL 1). An operation of the current-source unit is roughly classified as a single-ended operation and a differential operation. In the single-ended operation, whether to output the current from the current-source cell or discard the current as a dummy is switched by two switches. In the differential operation, whether to output the current from the current-source cell as a positive-side output or a negative-side output is switched by two switches.

A quad switching current-source cell in which two sets of a pair of two switches are connected to a single current source is proposed (see, for example, NPL 2). While one of the two sets is operating, the other performs decoding processing of the next input data, and thereby outputs are alternately taken. Consequently, since the delay in the logic circuit is concealed, it is possible to increase the conversion speed.

After a digital signal is input to a sub-DAC, a certain transition time is required for an output voltage to gradually transition and settle into a final value. Therefore, it was proposed to provide two sets of sub-DACs having quad switching current-source cells, operate the sub-DACs alternately (time-interleaved operation), and selectively take out an output by a multiplexer (see, for example, NPL 3). A total of four sets of switches is switched with a phase difference of 90°. No voltage is output during a transition period of the first half of operation of each set, and a voltage that has settled to a final value in the second half of operation is taken out as an output. Consequently, since the transition time of the output voltage of the sub-DAC is reduced, it is possible to achieve a conversion speed two times faster than that of a single sub-DAC.

### Citation List

### Non Patent Literature

[NPL 1] A. van den Bosch, et al., "A 10-bit 1-GSample/s Nyquist current-steering CMOS D/A converter," IEEE JSSC, Mar. 2001.
[NPL 2] B. Schafferer, et al., "A 3V CMOS 400mW 14b 1.4GS/s DAC for Multi-Carrier Applications," IEEE ISSCC2004.
[NPL 3] E. Olieman, et al., "An Interleaved Full Nyquist High-Speed DAC Technique," IEEE JSSC, Mar. 2015.

### Summary of the Invention

### Technical Problem

With the quad switching DAC of NPL 2, achieving a conversion speed that was twice as fast was the limit. To achieve a higher speed, NPL 3 uses a multiplexer to cause two sets of sub-DACs to perform time-interleaved operations. However, since each of the two sets of sub-DACs uses a separate current source, an offset occurs if there is an error in the current values of these current sources, and an analog output voltage deviates from an ideal value of the digital input. Moreover, a gain error also occurs in which an output voltage range deviates from ideal values.

Further, in NPL 3, a multiplexer that selectively takes out an output of the sub-DAC is present outside the sub-DAC. Therefore, the magnitude of the current flowing through the multiplexer changes depending on the digital input. Since the drain voltage/current characteristics of a transistor are not linear, a nonlinear error occurs in which a voltage drop caused by the transistor of the multiplexer is not linear with respect to a change in the digital input. Therefore, the analog output voltage deviates from an ideal value of the digital input.

Furthermore, the DAC of NPL 3 performs a return-to-zero (RZ) operation to deliver the output current of one of two sets of sub-DACs to a dummy. Consequently, half of the current from the current-source cell is discarded, which is disadvantageous in terms of power efficiency.

The present invention has been made to solve the above-mentioned problems, and the purpose of the invention is to obtain a D/A converter that can prevent an offset, a gain error, and a nonlinear error, and improve power efficiency.

### Solution to the Problem

A D/A converter according to the present invention includes: a current-source cell having a plurality of current-source units connected in parallel with each other and outputting currents in response to a digital input respectively; and a resistor converting a total current of the plurality of current-source units into an analog output voltage, wherein each current-source unit inputs first to fourth overlapping clocks having phases sequentially shifted by 90° and first to fourth digital inputs which are portions of the digital input corresponding to each current-source unit and synchronized with the first to fourth overlapping clocks respectively, each current-source unit has first to fourth switch sections connected in parallel with each other, and a current source connected in series with the first to fourth switch sections, the first switch section outputs a current from the current source in response to the first digital input during a period in which the first and second overlapping clocks overlap, the second switch section outputs a current from the current source in response to the second digital input during a period in which the second and third overlapping clocks overlap, the third switch section outputs a current from the current source in response to the third digital input during a period in which the third and fourth overlapping clocks overlap, the fourth switch section outputs a current from the current source in response to the fourth digital input during a period in which the fourth and first overlapping clocks overlap.

### Advantageous Effects of the Invention

In the present invention, since the first to fourth switch sections use the common current source, offset and gain errors can be prevented. Moreover, since the first to fourth switch sections for switching operations are present in the current-source unit and the magnitude of the current flowing through the first to fourth switch sections does not depend on the digital input, nonlinearity errors do not occur. Further, since the current-source unit performs the NRZ operation, power efficiency can be improved.

### Brief Description of the Drawings

FIG. 1 is a circuit diagram showing a D/A converter according to Embodiment 1.
FIG. 2 is a circuit diagram showing the current-source unit according to Embodiment 1.
FIG. 3 is a timing chart showing an operation of the current-source unit according to Embodiment 1.
FIG. 4 is a circuit diagram showing the current-source unit according to Embodiment 2.
FIG. 5 is a timing chart showing operations of the current-source unit according to Embodiment 2.

### Description of Embodiments

A D/A converter according to the embodiments of the present invention will be described with reference to the drawings. The same components will be denoted by the same symbols, and the repeated description thereof may be omitted.

### Embodiment 1

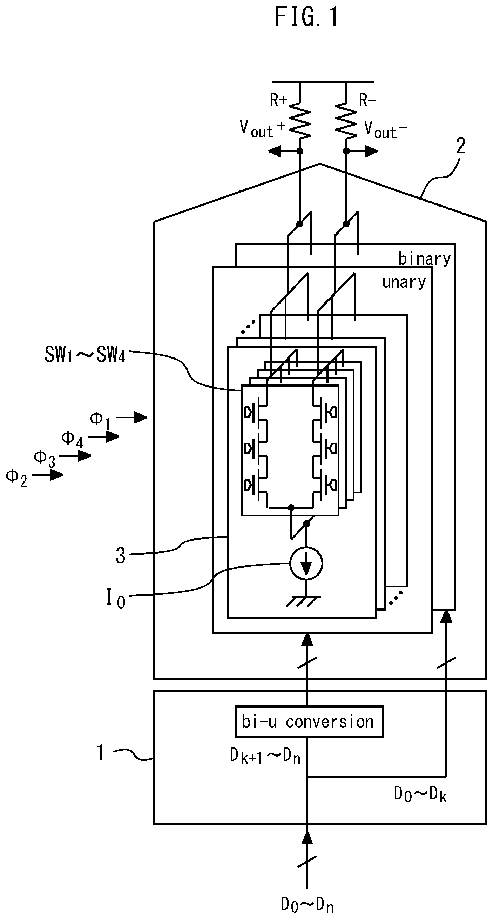

FIG. 1 is a circuit diagram showing a D/A converter according to Embodiment 1. A logic circuit 1 processes digital inputs D₀ to Dₙ, and inputs the digital inputs D₀ to Dₙ to a current-source cell 2. Four-phase overlapping clocks Φ₁ to Φ₄ having phases sequentially shifted by 90° are also input to the current-source cell 2. Overlapping clocks with adjacent numbers, for example, the overlapping clocks Φ₁ and Φ₂ have phases shifted by 90° and overlap by only a 1/4 period. Note that the overlapping clocks Φ₁ to Φ₄ are generated, for example, by a four-phase clock generator disclosed in Japanese Patent No. 4152969.

The current-source cell 2 has a plurality of current-source units 3 connected in parallel with each other. The plurality of current-source units 3 output currents in response to the corresponding digital inputs, respectively. Resistors R+ and R- are connected between the current-source cell 2 and a power source. The resistor R+ converts the total current of the plurality of current-source units 3 into an analog output voltage Vₒᵤₜ+. The current-source units 3 differentially operate, and the resistor R- converts the total current of inverted outputs of the plurality of current-source units 3 into an analog output voltage Vₒᵤₜ-.

The current-source unit 3 has switch sections SW₁ to SW₄ connected in parallel with each other, and a current source I₀ connected in series with the switch sections SW₁ to SW₄. The current-source cell 2 has a segment configuration in which the current-source units 3 corresponding to the higher side Dₖ₊₁ to Dₙ of the digital inputs D₀ to Dₙ are configured as a unary configuration, and the current-source units 3 corresponding to the lower side D₀ to Dₖ of the digital inputs D₀ to Dₙ are configured as a binary configuration.

For example, in a DAC having an 8-bit configuration, the unary configuration of the higher 5 bits is constituted by 31 current-source units 3 that deliver the same current, and the binary configuration of the lower 3 bits is constituted by the current-source units 3 including the current sources I₀ with a current ratio of 1, 2, and 4. The current values of the current sources I₀ of the plurality of current-source units 3 in the unary configuration are the same.

The current values of the current sources I₀ of the plurality of current-source units 3 in the binary configuration are weighted with a current value ratio of powers of 2. The logic circuit 1 performs decoding processing for converting binary codes Dₖ₊₁ to Dₙ, which are input to the current-source units 3 of the unary configuration, into thermometer codes.

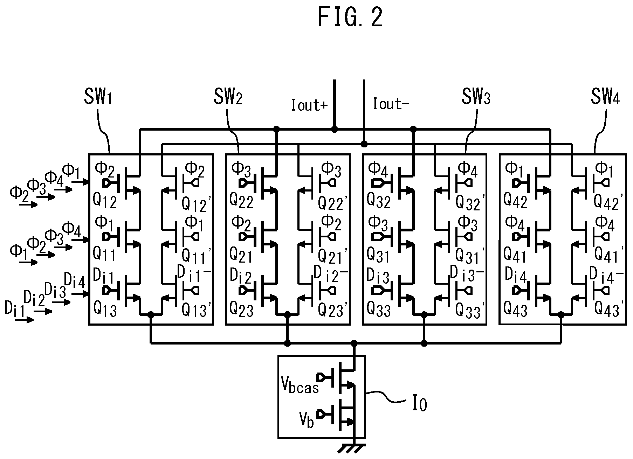

FIG. 2 is a circuit diagram showing the current-source unit according to Embodiment 1. The current source I₀ is constituted by two transistors controlled by voltages Vb and Vbcas, respectively, and delivers a constant current. The switch sections SW₁ to SW₄ are connected to a drain of the current source I₀.

Digital inputs Dᵢ₁ to Dᵢ₄ are portions of a digital input Dᵢ corresponding to the ith current-source unit 3 and synchronized with the overlapping clocks Φ₁ to Φ₄, respectively. The digital inputs Dᵢ₁ to Dᵢ₄ are sequentially input to the current-source unit 3 with a phase difference of 90°. The logic circuit 1 generates the digital inputs Dᵢ₁ to Dᵢ₄ from the digital input Dᵢ corresponding to the current-source unit 3.

The switch section SW₁ has transistors Q₁₁ to Q₁₃ connected in series with each other, and transistors Q₁₁' to Q₁₃' connected in series with each other. The transistors Q₁₁ to Q₁₃ and the transistors Q₁₁' to Q₁₃' are connected in parallel with each other. Similarly, the switch section SW₂ has transistors Q₂₁ to Q₂₃ connected in series with each other, and transistors Q₂₁' to Q₂₃' connected in series with each other. The switch section SW₃ has transistors Q₃₁ to Q₃₃ connected in series with each other, and transistors Q₃₁' to Q₃₃' connected in series with each other. The switch section SW₄ has transistors Q₄₁ to Q₄₃ connected in series with each other, and transistors Q₄₁' to Q₄₃' connected in series with each other.

The transistors Q₁₁ to Q₁₃ are controlled by the overlapping clock Φ₁, the overlapping clock Φ₂, and the digital input Dᵢ₁, respectively. The transistors Q₂₁ to Q₂₃ are controlled by the overlapping clock Φ₂, the overlapping clock Φ₃, and the digital input Dᵢ₂, respectively. The transistors Q₃₁ to Q₃₃ are controlled by the overlapping clock Φ₃, the overlapping clock Φ₄, and the digital input Dᵢ₃, respectively. The transistors Q₄₁ to Q₄₃ are controlled by the overlapping clock Φ₄, the overlapping clock Φ₁, and the digital input Dᵢ₄, respectively.

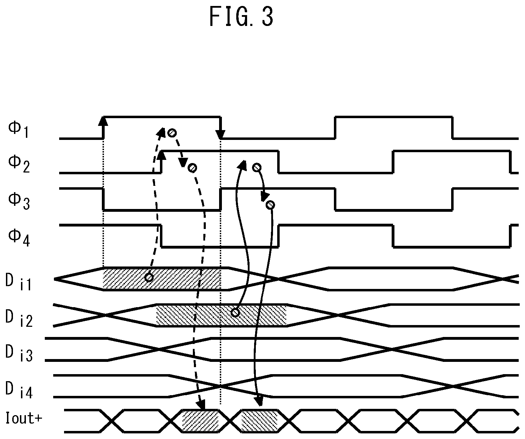

FIG. 3 is a timing chart showing an operation of the current-source unit according to Embodiment 1. After the digital input Dᵢ₁ transitions to "1", the transistor Q₁₁ turns on in synchronization with a transition of the overlapping clock Φ₁ to "1". Thereafter, the transistor Q₁₂ also turns on in synchronization with a transition of the overlapping clock Φ₂ to "1". In a period in which both the overlapping clocks Φ₁ and Φ₂ are "1", the transistor Q₁₃ turns on/off in response to the digital input Dᵢ₁, and the switch section SW₁ outputs the current from the current source I₀.

When the digital input Dᵢ₁ is "1", the current from the current source I₀ is delivered to Iₒᵤₜ+, and when the digital input Dᵢ₁ is "0", the current is delivered to Iₒᵤₜ-. In other words, the digital input Dᵢ₁ determines whether the current from the current source I₀ is delivered to Iₒᵤₜ+ or Iₒᵤₜ-, and the timing for delivering the current is controlled by the overlapping clocks Φ₁ and Φ₂.

Then, when the overlapping clock Φ₁ transitions to "0", the transistor Q₁₁ turns off, and the output of the current from the switch section SW₁ stops. Thereafter, Dᵢ₂ transitions to "1" and a similar operation is performed in the switch section SW₂, Dᵢ₃ transitions to "1" and a similar operation is performed in the switch section SW₃, and Dᵢ₄ transitions to "1" and a similar operation is performed in the switch section SW₄.

The switch section SW₁ outputs the current from the current source I₀ in response to the digital input Dᵢ₁ during a period in which the overlapping clocks Φ₁ and Φ₂ overlap. The switch section SW₂ outputs the current from the current source I₀ in response to the digital input Dᵢ₂ during a period in which the overlapping clocks Φ₂ and Φ₃ overlap. The switch section SW₃ outputs the current from the current source I₀ in response to the digital input Dᵢ₃ during a period in which the overlapping clocks Φ₃ and Φ₄ overlap. The switch section SW₄ outputs the current from the current source I₀ in response to the digital input Dᵢ₄ during a period in which the overlapping clocks Φ₄ and Φ₁ overlap.

Thus, based on four-phase clocks with a phase difference of 90°, the switch sections SW₁ to SW₄ perform time-interleaved operations in the current-source unit 3. Consequently, since the current from the current source I₀ is output as one of the switch sections SW₁ to SW₄ operates, a non-return-to-zero (NRZ) operation is performed.

As described above, in the present embodiment, since the switch sections SW₁ to SW₄ of the current-source unit 3 use the common current source I₀, offset and gain errors can be prevented. Moreover, since the switch sections SW₁ to SW₄ for switching operations are present in the current-source unit 3 and the magnitude of the current flowing through the switch sections SW₁ to SW₄ does not depend on the digital input, nonlinearity errors do not occur. Further, since the current-source unit 3 performs the NRZ operation, power efficiency can be improved.

Note that the logic circuit 1 is realized by a processing circuit, such as a CPU or a system LSI, which executes a program stored in memory. Furthermore, a plurality of processing circuits may perform the above functions in cooperation with each other.

### Embodiment 2

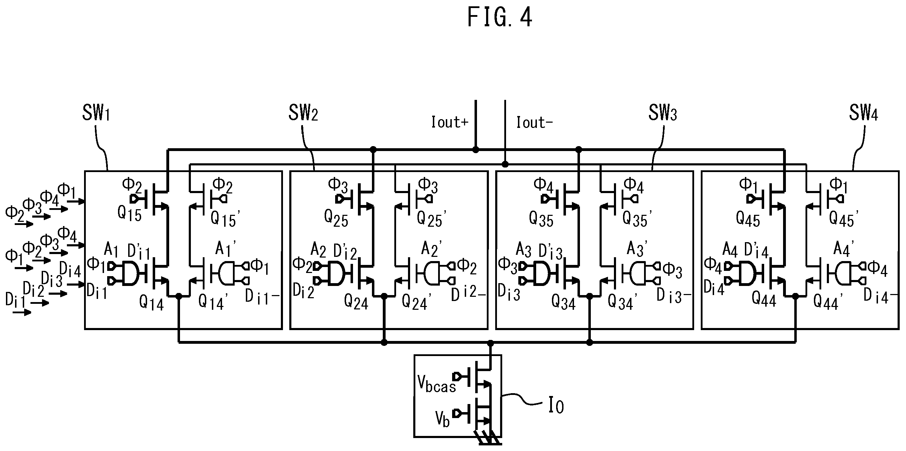

FIG. 4 is a circuit diagram showing the current-source unit according to Embodiment 2. The switch section SW₁ has AND circuits A₁ and A₁', transistors Q₁₄ and Q₁₅ connected in series with each other, and transistors Q₁₄' and Q₁₅' connected in series with each other. The switch section SW₂ has AND circuits A₂ and A₂', transistors Q₂₄ and Q₂₅ connected in series with each other, and transistors Q₂₄' and Q₂₅' connected in series with each other. The switch section SW₃ has AND circuits A₃ and A₃', transistors Q₃₄ and Q₃₅ connected in series with each other, and transistors Q₃₄' and Q₃₅' connected in series with each other. The switch section SW₄ has AND circuits A₄ and A₄', transistors Q₄₄ and Q₄₅ connected in series with each other, and transistors Q₄₄' and Q₄₅' connected in series with each other.

The overlapping clock Φ₁ and the digital input Dᵢ₁ have basically the same timing. Therefore, the AND circuit A₁ performs an AND operation on the overlapping clock Φ₁ and the digital input Dᵢ₁. The transistor Q₁₄ is controlled by an output Dᵢ₁' of the AND circuit A₁. The transistor Q₁₅ is controlled by the overlapping clock Φ₂. The AND circuit A₁' performs an AND operation on the overlapping clock Φ₁ and a digital input Dᵢ₁-. The transistor Q₁₄' is controlled by an output of the AND circuit A₁'. The transistor Q₁₅' is controlled by the overlapping clock Φ₂.

The AND circuit A₂ performs an AND operation on the overlapping clock Φ₂ and the digital input Dᵢ₂. The transistor Q₂₄ is controlled by an output Dᵢ₂' of the AND circuit A₂. The transistor Q₂₅ is controlled by the overlapping clock Φ₃. The AND circuit A₂' performs an AND operation on the overlapping clock Φ₂ and a digital input Dᵢ₂-. The transistor Q₂₄' is controlled by an output of the AND circuit A₂'. The transistor Q₂₅' is controlled by the overlapping clock Φ₃.

The AND circuit A₃ performs an AND operation on the overlapping clock Φ₃ and the digital input Dᵢ₃. The transistor Q₃₄ is controlled by an output Dᵢ₃' of the AND circuit A₃. The transistor Q₃₅ is controlled by the overlapping clock Φ₄. The AND circuit A₃' performs an AND operation on the overlapping clock Φ₃ and a digital input Dᵢ₃-. The transistor Q₃₄' is controlled by an output of the AND circuit A₃'. The transistor Q₃₅' is controlled by the overlapping clock Φ₄.

The AND circuit A₄ performs an AND operation on the overlapping clock Φ₄ and the digital input Dᵢ₄. The transistor Q₄₄ is controlled by an output Dᵢ₄' of the AND circuit A₄. The transistor Q₄₅ is controlled by the overlapping clock Φ₁. The AND circuit A₄' performs an AND operation on the overlapping clock Φ₄ and a digital input Dᵢ₄-. The transistor Q₄₄' is controlled by an output of the AND circuit A₄'. The transistor Q₄₅' is controlled by the overlapping clock Φ₁.

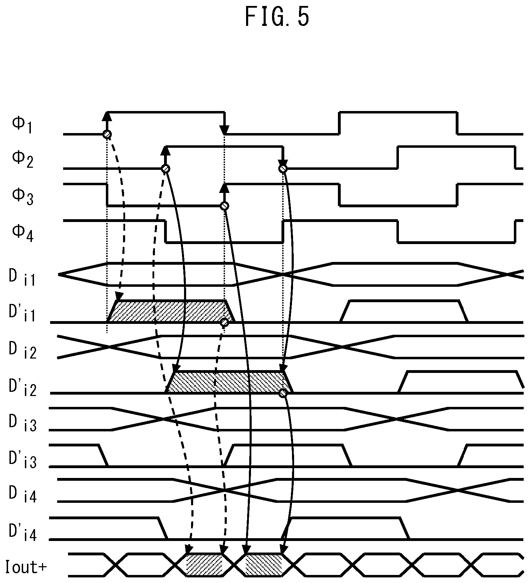

FIG. 5 is a timing chart showing operations of the current-source unit according to Embodiment 2. As in Embodiment 1, the switch sections SW₁ to SW₄ perform time-interleaved operations in the current-source unit 3, based on four-phase clocks having a phase difference of 90°. In other words, the switch section SW₁ outputs the current from the current source I₀ in response to the digital input Dᵢ₁ during a period in which the overlapping clocks Φ₁ and Φ₂ overlap. The switch section SW₂ outputs the current from the current source I₀ in response to the digital input Dᵢ₂ during a period in which the overlapping clocks Φ₂ and Φ₃ overlap.

The switch section SW₃ outputs the current from the current source I₀ in response to the digital input Dᵢ₃ during a period in which the overlapping clocks Φ₃ and Φ₄ overlap. The switch section SW₄ outputs the current from the current source I₀ in response to the digital input Dᵢ₄ during a period in which the overlapping clocks Φ₄ and Φ₁ overlap. Consequently, the same effect as in Embodiment 1 can be obtained.

Moreover, in the present embodiment, since the AND circuits are used, the number of stages of transistors in each of the switch sections SW₁ to SW₄ is one stage less than that in Embodiment 1. Consequently, an output voltage range can be expanded by only an amount corresponding to one transistor stage.

Note that it is also possible to perform an AND operation on the overlapping clocks Φ₁ and Φ₂ to make the transistors Q₁₁ and Q₁₂ of Embodiment 1 one stage. In this case, the number of stages of transistors is also reduced by one stage. However, since the pulse width during the "1" period after the AND processing becomes narrower with an increase in the operating speed, the speed limit is lower than it is when no AND processing is performed.

### List of Reference Signs

- 1: logic circuit
- 2: current-source cell
- 3: current-source unit
- A₁ to A₄: AND circuit
- D₀ to Dₙ: digital input
- Dᵢ₁ to Dᵢ₄: digital input
- I₀: current source
- Q₁₁ to Q₄₅: transistor
- R+,R-: resistor
- SW₁ to SW₄: switch section
- Φ₁ to Φ₄: overlapping clock

## Claims

1. A D/A converter comprising:
a current-source cell having a plurality of current-source units connected in parallel with each other and outputting currents in response to a digital input respectively; and
a resistor converting a total current of the plurality of current-source units into an analog output voltage,
wherein each current-source unit inputs first to fourth overlapping clocks having phases sequentially shifted by 90° and first to fourth digital inputs which are portions of the digital input corresponding to each current-source unit and synchronized with the first to fourth overlapping clocks respectively,
each current-source unit has first to fourth switch sections connected in parallel with each other, and a current source connected in series with the first to fourth switch sections,
the first switch section outputs a current from the current source in response to the first digital input during a period in which the first and second overlapping clocks overlap,
the second switch section outputs a current from the current source in response to the second digital input during a period in which the second and third overlapping clocks overlap,
the third switch section outputs a current from the current source in response to the third digital input during a period in which the third and fourth overlapping clocks overlap,
the fourth switch section outputs a current from the current source in response to the fourth digital input during a period in which the fourth and first overlapping clocks overlap.

2. The D/A converter according to claim 1,
further comprising a logic circuit generating the first to fourth digital inputs from the digital input corresponding to each current-source unit.

3. The D/A converter according to claim 1 or 2,
wherein the first switch section has first to third transistors connected in series with each other,
the first to third transistors are controlled by the first overlapping clock, the second overlapping clock, and the first digital input respectively,
the second switch section has fourth to sixth transistors connected in series with each other,
the fourth to sixth transistors are controlled by the second overlapping clock, the third overlapping clock, and the second digital input respectively,
the third switch section has seventh to ninth transistors connected in series with each other,
the seventh to ninth transistors are controlled by the third overlapping clock, the fourth overlapping clock, and the third digital input respectively,
the fourth switch section has tenth to twelfth transistors connected in series with each other, and
the tenth to twelfth transistors are controlled by the fourth overlapping clock, the first overlapping clock, and the fourth digital input respectively.

4. The D/A converter according to claim 1 or 2,
wherein the first switch section has a first AND circuit, and first and second transistors connected in series with each other,
the first AND circuit performs an AND operation on the first overlapping clock and the first digital input,
the first and second transistors are controlled by an output of the first AND circuit, and the second overlapping clock respectively,
the second switch section has a second AND circuit, and third and fourth transistors connected in series with each other,
the second AND circuit performs an AND operation on the second overlapping clock and the second digital input,
the third and fourth transistors are controlled by an output of the second AND circuit, and the third overlapping clock respectively,
the third switch section has a third AND circuit, and fifth and sixth transistors connected in series with each other,
the third AND circuit performs an AND operation on the third overlapping clock and the third digital input,
the fifth and sixth transistors are controlled by an output of the third AND circuit, and the fourth overlapping clock respectively,
the fourth switch section has a fourth AND circuit, and seventh and eighth transistors connected in series with each other,
the fourth AND circuit performs an AND operation on the fourth overlapping clock and the fourth digital input, and
the seventh and eighth transistors are controlled by an output of the fourth AND circuit, and the first overlapping clock respectively.

5. The D/A converter according to claim 1 or 2,
wherein the current-source cell has a segment configuration in which the current-source units corresponding to a higher side of the digital input are configured as a unary configuration, and the current-source units corresponding to a lower side of the digital input are configured as a binary configuration,
current values of the current sources of the current-source units in the unary configuration are the same, and
current values of the current sources of the current-source units in the binary configuration are weighted with a current value ratio of powers of 2.

6. The D/A converter according to claim 1 or 2,
wherein the current-source units differentially operate.
